Europäisches Patentamt

European Patent Office

Office européen des brevets

(11) Numéro de publication: **0 415 836 A1**

## DEMANDE DE BREVET EUROPEEN

(21) Numéro de dépôt: **90402368.6**

(22) Date de dépôt: **27.08.90**

(51) Int. Cl.⁵: **H03K 3/53**, H03K 3/57

(30) Priorité: **29.08.89 FR 8911332**

(43) Date de publication de la demande:
**06.03.91 Bulletin 91/10**

(84) Etats contractants désignés:
**BE DE GB**

(71) Demandeur: **COMMISSARIAT A L'ENERGIE ATOMIQUE Etablissement de Caractère Scientifique Technique et Industriel**

**31/33, rue de la Fédération
F-75015 Paris(FR)**

(72) Inventeur: **Roche, Michel
12 rue de Saulx Tavannes
F-21000 Dijon(FR)**

(74) Mandataire: **Mongrédien, André et al
c/o BREVATOME 25, rue de Ponthieu
F-75008 Paris(FR)**

(54) Générateur d'impulsions électriques de haute tension.

(57) Générateur d'impulsions électriques de haute tension.

Ce générateur comprend des générateurs d'impulsions élémentaires montés en série, comportant chacun des moyens (C1,..., Cn) d'accumulation d'énergie électrique et un commutateur (CA1,..., CAn) dont la fermeture provoque la décharge des moyens d'accumulation ; des moyens (T1-L1,..., Tn-Ln) de commande des commutateurs, électriquement indépendants les uns des autres et prévus pour fermer simultanément les commutateurs de façon impulsionnelle ; des moyens (G1-G'1,..., Gn-G'n) de chargement des moyens d'accumulation, dont la dépendance électrique mutuelle est suffisamment faible pour ne pas entraîner une perte excessive de puissance en sortie du générateur.

Application aux accélérateurs de particules.

FIG.9

## GENERATEUR D'IMPULSIONS ELECTRIQUES DE HAUTE TENSION

La présente invention concerne un générateur d'impulsions électriques de haute tension. Elle s'applique notamment à l'alimentation électrique de générateurs de micro-ondes ou de générateurs de rayonnements électromagnétiques de haute fréquence. L'invention trouve en particulier des applications dans le domaine des radars et des accélérateurs de particules.

Le générateur objet de l'invention est capable de fournir des impulsions électriques de forme rectangulaire, de grande amplitude. Pour ce faire, on connaît déjà des générateurs qui utilisent la décharge de lignes à retard. Ces lignes peuvent être des lignes dites "à constantes localisées", de telles lignes comportant un réseau d'inductances et de condensateurs qui sont disposés suivant un motif périodique, ou des lignes dites "à constantes réparties", ces dernières étant des lignes coaxiales à diélectrique solide ou liquide.

Chacune de ces lignes à constantes localisées ou à constantes réparties comporte un commutateur de décharge qui peut être un éclateur, un thyratron, un ignitron, un thyristor ou même, dans certains cas, un transistor.

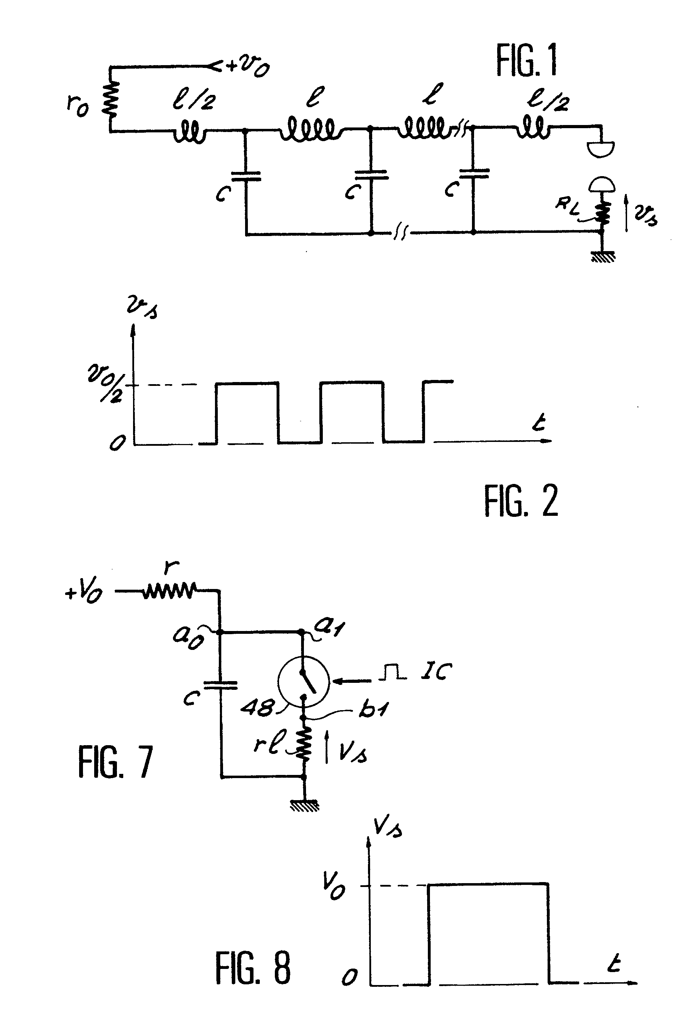

Diverses réalisations de tels générateurs sont connues. L'une d'entre elles est schématiquement représentée sur la figure 1 où l'on voit une ligne qui comporte un réseau d'inductances et de condensateurs disposés suivant un motif périodique, chacun des condensateurs ayant une capacité c et la valeur des inductances étant notée l , excepté en chaque extrémité de la ligne où l'inductance vaut l /2. Un commutateur de décharge, par exemple constitué par un éclateur, est placé à une extrémité de la ligne.

Entre la masse et l'autre extrémité de cette ligne, on applique, par l'intermédiaire d'une résistance électrique appropriée ro, une tension électrique continue au cours du temps, de va leur + vo. Ceci permet d'obtenir, entre les bornes d'une charge symbolisée par une résistance RL, qui est montée entre une borne de l'éclateur et la masse, une tension vs dont la courbe des variations au cours du temps t est en forme de créneaux et dont l'amplitude maximale vaut vo/2 (figure 2).

Ces générateurs connus présentent des inconvénients : Chacun d'entre eux nécessite une ligne à retard qui est coûteuse et encombrante ; de plus, la largeur des impulsions électriques produites ne peut être modifiée sans changer cette ligne ; enfin, la fréquence de récurrence de ces impulsions est généralement limitée, du fait du commutateur de décharge, à une valeur inférieure à 1 kHz.

La présente invention a pour but de remédier aux inconvénients précédents en proposant un générateur d'impulsions électriques de haute tension qui, à tensions de sortie égales, est moins coûteux et moins encombrant que ces générateurs connus, qui permet une variation de la largeur des impulsions produites et qui, dans certaines réalisations particulières, est capable de fournir des impulsions électriques dont la fréquence de récurrence est supérieure à 1 kHz.

De façon précise, la présente invention a pour objet un générateur d'impulsions électriques, caractérisé en ce qu'il comprend :
- une pluralité de générateurs d'impulsions électriques élémentaires qui sont montés en série, chaque générateur d'impulsions électriques élémentaires comprenant :
- des moyens d'accumulation d'énergie électrique, et
- un commutateur dont la fermeture provoque la décharge des moyens d' accumulation d'énergie électrique,
- des moyens de commande des commutateurs, ces moyens de commande étant électriquement indépendants les uns des autres et prévus pour fermer simultanément les commutateurs de façon impulsionnelle, le montage en série des générateurs d'impulsions électriques élémentaires étant tel que le générateur produise alors une impulsion électrique de grande amplitude, égale à la somme des impulsions électriques élémentaires résultant de la fermeture simultanée des commutateurs, et
- des moyens de chargement en énergie électrique des moyens d'accumulation, moyens de chargement dont la dépendance électrique mutuelle est nulle ou en tout cas suffisamment faible pour ne pas entraîner une perte excessive de puissance en sortie du générateur.

Dans une réalisation particulière du générateur objet de l'invention, qui conduit à un générateur de grande compacité, les générateurs d'impulsions électriques élémentaires sont empilés suivant un axe et placés dans une enceinte qui est électriquement conductrice et mise à la masse et qui a la forme d'un tube dont l'axe est celui de l'empilement des générateurs d'impulsions électriques élémentaires, ces derniers formant le conducteur interne d'une ligne coaxiale dont le conducteur externe est formé par l'enceinte.

Selon un mode de réalisation particulier du générateur objet de l'invention, qui est intéressant du point de vue du coût, de la compacité, de la variabilité de la durée des impulsions produites et de la fréquence de récurrence de ces dernières, chaque commutateur comprend :
- une pluralité de dispositifs semi-conducteurs, chaque dispositif semi-conducteur comportant un ensemble de deux électrodes, entre lesquelles le signal de sortie relatif à ce dispositif semi-conducteur est disponible, et une électrode de commande, les dispositifs semi-conducteurs étant montés en série par l'intermédiaire des ensembles de deux électrodes,

- une pluralité de transformateurs toriques qui sont respectivement associés aux dispositifs semi-conducteurs, chaque transformateur comportant un circuit primaire, un noyau en forme d'anneau et un circuit secondaire, le noyau en forme d'anneau et le circuit primaire étant communs à tous les transformateurs toriques, les dispositifs semi-conduteurs étant disposés suivant un cercle entourant le noyau en forme d'anneau, le circuit primaire faisant office de circuit de commande du commutateur, chaque circuit secondaire étant monté entre l'électrode de commande du dispositif semi-conducteur correspondant et l'une des deux électrodes de ce dernier, entre lesquelles le signal de sortie relatif à ce dispositif est disponible, et

- une pluralité d'éléments d'équilibrage qui sont respectivement associés aux dispositifs semi-conducteurs et qui sont prévus pour assurer l'équilibrage des tensions entre tous ces dispositifs semi-conducteurs, chaque élément d'équilibrage étant monté entre les deux électrodes de l'ensemble de deux électrodes du dispositif semi-conducteur correspondant.

Les moyens de commande des commutateurs peuvent être de type photoélectrique.

Dans ce cas, les moyens de commande des commutateurs peuvent par exemple comprendre :

- des fibres optiques qui sont respectivement associées aux commutateurs,

- des moyens d'émission de lumière et d'injection de celle-ci à une extrémité de chaque fibre optique, et

- à l'autre extrémité de chaque fibre optique, des moyens de détection de la lumière et d'activation du commutateur associé.

Les moyens de chargement des moyens d'accumulation peuvent être de type inductif.

Dans ce cas, les moyens de chargement des moyens d'accumulation peuvent par exemple comprendre :

- des moyens d'émission d'ondes électromagnétiques de haute fréquence et

- pour chaque générateur d'impulsions électriques élémentaires, une bobine d'induction qui est prévue pour détecter ces ondes et qui est reliée aux moyens d'accumulation d'énergie électrique correspondants par l'intermédiaire de moyens de redressement de tension.

Dans une autre réalisation particulière de l'invention, les moyens de chargement des moyens d'accumulation comprennent :

- pour chaque générateur d'impulsions électriques élémentaires, deux résistances électriques respectivement connectées aux bornes des moyens d'accumulation d'énergie électrique correspondants, et

- une source de tension électrique continue dont une borne est mise à la masse et qui est montée entre les bornes des moyens d'accumulation de chaque générateur d'impulsions électriques élémentaires par l'intermédiaire des résistances électriques correspondantes, les valeurs des résistances électriques du générateur étant suffisamment faibles pour ne pas entraîner une perte excessive de puissance en sortie du générateur.

Enfin, les moyens de chargement des moyens d'accumulation peuvent être de type mécanique.

Dans ce cas, les moyens de chargement des moyens d'accumulation peuvent par exemple comprendre :

- une pluralité de moyens électriques rotatifs qui sont respectivement associés aux générateurs d'impulsions électriques élémentaires, chaque moyen électrique rotatif étant prévu pour appliquer, lorsqu'il tourne, une tension électrique continue entre les bornes des moyens d'accumulation d'énergie électrique du générateur d'impulsions électriques élémentaires associé,

- un arbre rotatif comportant des tronçons qui sont électriquement isolés les uns des autres, qui sont respectivement associés aux moyens rotatifs et qui sont prévus pour entraîner en rotation ces moyens rotatifs, et

- des moyens de rotation de l'arbre.

En variante, les moyens de chargement des moyens d'accumulation peuvent par exemple comprendre :

- une pluralité de moyens électriques rotatifs qui sont respectivement associés aux générateurs d'impulsions électriques élémentaires, chaque moyen électrique rotatif étant prévu pour appliquer, lorsqu'il tourne, une tension électrique continue entre les bornes des moyens d'accumulation d'énergie électrique du générateur d'impulsions électriques élémentaires associé,

- des moyens d'entraînement aptes à entraîner en rotation ces moyens rotatifs sous l'effet d'un fluide en circulation, et

-une canalisation qui est destinée à la circulation d'un fluide électriquement isolant et dans laquelle sont placés les moyens d'entraînement.

La présente invention sera mieux comprise à la lecture de la description suivante d'exemples de réalisation donnés à titre purement indicatif et nullement limitatif en référence aux dessins annexés sur lesquels :

- la figure 1 est une vue schématique d'un générateur connu d'impulsions électriques et a déjà été décrite,

- la figure 2, déjà décrite, est la courbe des variations temporelles de la tension électrique engendrée par le générateur représenté sur la figure 1,

- la figure 3 est un schéma fonctionnel d'un commutateur utilisable dans la présente invention,

- la figure 4 illustre schématiquement et partiellement une réalisation possible du commutateur de la figure 3,

- la figure 5 illustre schématiquement et partiellement une autre réalisation possible du commutateur de la figure 3,

- les figures 6A, 6B et 6C illustrent schématiquement trois réalisations possibles d'éléments d'équilibrage qui sont utilisés dans le commutateur de la figure 3,

- la figure 7 est un schéma électrique d'un générateur d'impulsions électriques réalisé au moyen du commutateur de la figure 3,

- la figure 8 représente les variations temporelles d'une tension électrique que l'on peut obtenir au moyen du générateur représenté sur la figure 7,

- la figure 9 est un schéma électrique d'un générateur conforme à l'invention,

- la figure 10 est une vue schématique et partielle d'un mode de réalisation particulier du générateur objet de l'invention,

- la figure 11 est une vue en coupe schématique et partielle d'un générateur d'impulsions électriques élémentaires faisant partie du générateur représenté sur la figure 10,

- la figure 12 est un schéma électrique du générateur d'impulsions électriques élémentaires représenté sur la figure 11,

- la figure 13 est une vue schématique et partielle d'un deuxième mode de réalisation particulier du générateur objet de l'invention,

- la figure 14 est une vue schématique et partielle d'un troisième mode de réalisation particulier du générateur objet de l'invention, et

- la figure 15 est une variante de réalisation du générateur représenté sur la figure 14.

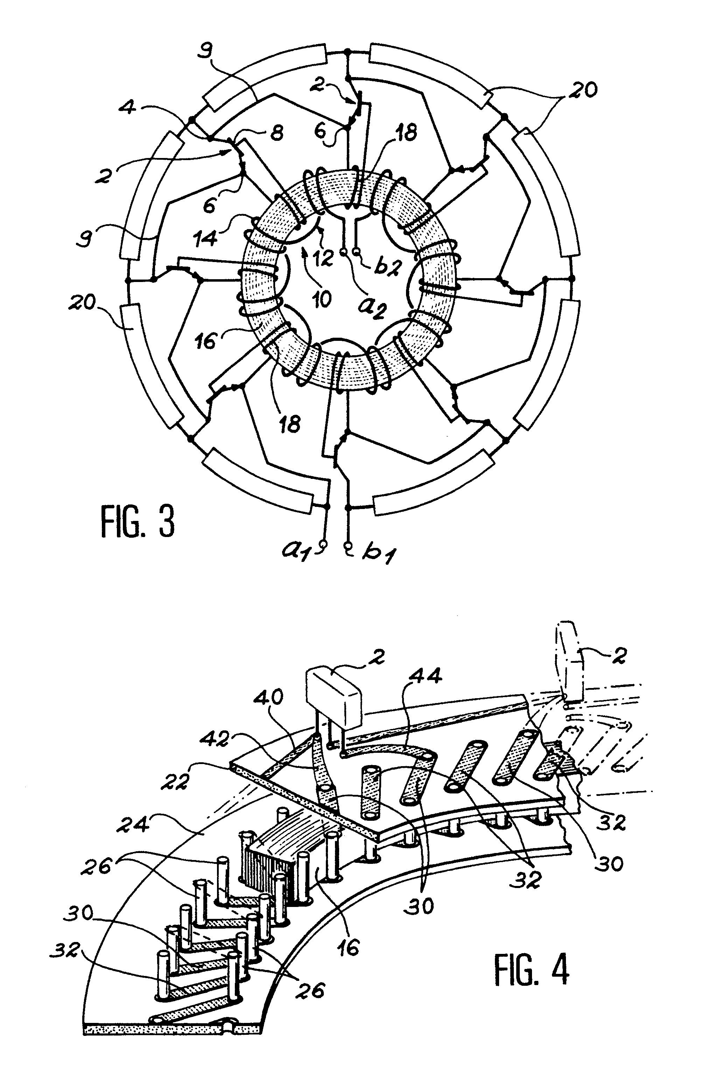

La figure 3 est un schéma fonctionnel d'un commutateur qui est appelé "commutateur en anneau" et qui est utilisable dans la présente invention. Il s'agit d'un commutateur à dispositifs semi-conducteurs qui sont appelés plus simplement par la suite "semi-conducteurs".

Le commutateur représenté sur la figure 3 comprend des éléments fonctionnels déjà utilisés dans des commutateurs de l'art antérieur. Il comprend en particulier un nombre N de semi-conducteurs 2, montés en série, un même nombre N de transformateurs 10 pour commander les semi-conducteurs 2, et un même nombre N d'éléments d'équilibrage 20 des semi-conducteurs 2. La fonction de ces éléments 20 sera indiquée par la suite.

La connexion en série des semi-conducteurs 2 est réalisée par l'intermédiaire de deux électrodes 4 et 6 dont chaque semi-conducteur 2 est pourvu et entre lesquelles on prélève le signal de sortie correspondant à ce semi-conducteur.

Chaque transformateur 10 comprend un circuit primaire 14, un noyau 16 et un circuit secondaire 18. Les semi-conducteurs 2 étant connectés en série, le noyau de chaque transformateur est constitué d'un noyau unique 16 en forme d'anneau. De manière analogue, les circuits primaires 14 des transformateurs 10 sont constitués par un unique circuit primaire ou ensemble primaire 12, les circuits primaires 14 étant ainsi connectés les uns aux autres. Les bornes de l'ensemble primaire 12 des circuits primaires 14 portent les références a2 et b2. Cet ensemble 12 de circuits primaires 14 constitue un circuit de commande pour la commutation de chacun des semi-conducteurs 2.

Chaque circuit secondaire 18 est connecté, d'une part, à l'électrode de commande 8 que comporte le semi-conducteur 2 correspondant et, d'autre part, à une électrode 6 faisant partie des deux électrodes entre lesquelles on prélève le signal de sortie du semi-conducteur 2.

Pour assurer la symétrie de l'ensemble des étages à semi-conducteur du commutateur, tous les circuits primaires 14 de l'ensemble primaire 12 ont le même nombre P de tours ou de spires, l'ensemble primaire 12 comportant alors un nombre total de spires égal à N.P. On prévoit également que les circuits secondaires 18 aient tous le même nombre Q de spires ou de tours.

Pour assurer l'équilibrage des tensions entre tous les semi-conducteurs 2, on monte entre les électrodes 4 et 6 de chaque semi-conducteur 2, un élément d'équilibrage 20. Un tel élément est opérationnel aussi bien pendant la phase d'ouverture que pendant la phase de fermeture du semi-conducteur correspondant.

Le circuit constitué par la connexion de tous les semi-conducteurs 2, par l'intermédiaire de leurs électrodes 4 et 6, se termine par deux bornes repérées a1 et b1.

Pour que l'ensemble des circuits compris entre a1 et b1 soit passant, il suffit qu'une impulsion d'amplitude et de signe convenables soit appliquée entre les bornes a2, b2 de l'ensemble 12 des circuits primaires 14. Chacun des semi-conducteurs 2 reçoit alors une impulsion sur son électrode de commande 8, impulsion qui le rend passant.

Sur la figure 3, les semi-conducteurs 2 ont été représentés sous la forme de transistors. Cette représentation n'est nullement limitative, un montage identique pouvant être réalisé avec des thyristors par exemple.

Dans le but d'obtenir une commutation rapide avec des semi-conducteurs 2 à forte capacité d'entrée tels que les circuits MOS (métal-oxyde-silicium) par exemple, ou les circuits mettant en jeu de très fortes variations de courant (di/dt), il est nécessaire d'envoyer sur les électrodes de commande (bases, grilles, gâchettes,... suivant les cas) des impulsions dont le front de montée est très bref et débitant un courant de très forte densité.

La réalisation représentée sur la figure 4 permet cette commutation rapide. En effet, l'inductance de fuite du transformateur de commande utilisé dans le commutateur représenté sur cette figure 4 est assez faible, car les configurations des bobinages primaire et secondaire sont identiques.

Le commutateur représenté sur la figure 4 est réalisé à l'aide de deux plaques 22 et 24 constituant des supports pour des circuits imprimés réalisés sous la forme de pistes de cuivre. Ces pistes constituent, entre autres, les éléments d'équilibrage non visibles sur cette figure 4, les parties 30, 32 des bobinages des circuits primaires et secondaires et les connexions 42 et 44 des semi-conducteurs 2 aux bobinages des circuits secondaires. Ces derniers, ainsi que les bobinages des circuits primaires, sont complétés par des barreaux 26 reliant les deux plaques 22 et 24 et connectés aux pistes de cuivre 30 et 32.

Les plaques 22 et 24 étant des pistes circulaires, pour respecter la forme du commutateur défini sur la figure 3, on remarque que les pistes de cuivre 30 et 32 sont légèrement inclinées par rapport au rayon correspondant à la circonférence de ces deux plaques 22 et 24. Par contre, pour constituer des bobinages s'intercalant entre chaque spire, le sens d'inclinaison des pistes 30 et 32 sur la première plaque supérieure 22 est opposé au sens d'inclinaison de ces mêmes pistes sur la plaque inférieure 24. De la sorte, chaque spire du bobinage d'un circuit primaire côtoie deux spires du bobinage d'un circuit secondaire, les bobinages des circuits primaire et secondaire étant insérés l'un dans l'autre.

Dans cette réalisation, le noyau torique 16 est placé entre les deux plaques 22 et 24 et entre les deux séries de barreaux 26. En conséquence, il a une section rectangulaire épousant la forme délimitée par ces deux plaques 22 et 24 complétées par les barreaux 26. Les semi-conducteurs sont câblés sur au moins une des deux plaques 22 et 24.

Le noyau 16 des transformateurs du commutateur peut être réalisé au moyen d'une bande de matériau ferromagnétique amorphe.

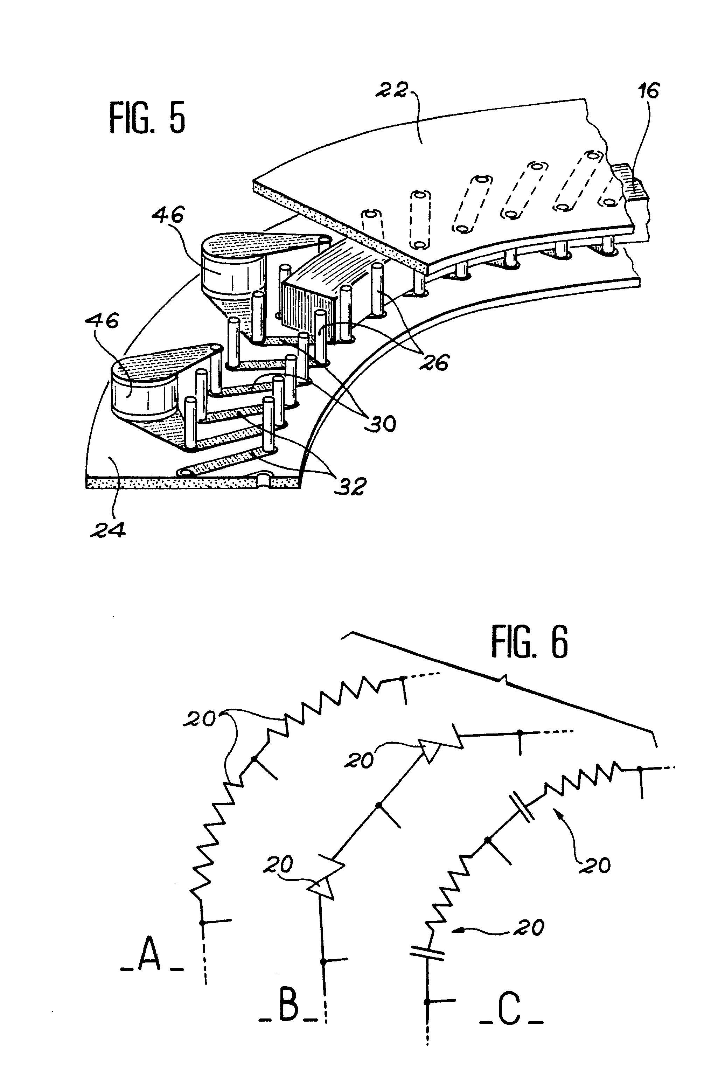

En se référant à la figure 5, si les semi-conducteurs, qui portent ici la référence 46, sont réalisés sous la forme de boîtiers du type "Prespack", ils peuvent être placés entre les deux plaques 22 et 24. Leur connexion se fait de manière analogue à celle qui est représentée sur la figure 4.

L'avantage fondamental de cette disposition particulière concerne notamment les barreaux 26 et réside dans le fait qu'il est possible de placer de façon très précise ces barreaux sur des cercles concentriques au noyau. En effet, les circuits primaires et secondaires ainsi découpés en bobinages indépendants occupent exactement la même place et ont une configuration symétrique. Cette disposition est par ailleurs très favorable à la répartition des capacités parasites, qui sont exactement les mêmes d'un étage de semi-conducteurs 46 à l'autre, du fait de la parfaite symétrie du circuit. Ceci est essentiel pour un bon équilibrage des tensions de chaque étage de semi-conducteur 46, pendant l'ouverture du circuit.

On remarque en particulier, en se reportant à la figure 5, la grande compacité d'un tel commutateur, sa facilité de construction et de montage et, par conséquent, son faible coût.

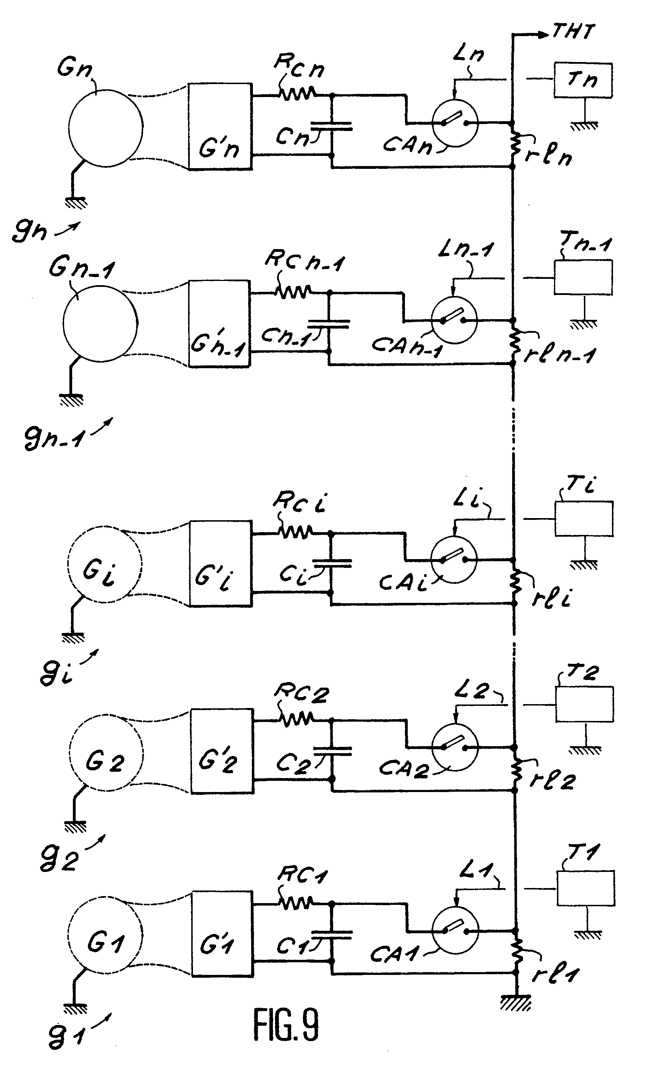

Les éléments d'équilibrage 20 peuvent être constitués de différentes manières. Une première réalisation, représentée par la figure 6A, consiste simplement à utiliser des résistances électriques. En se référant à la figure 6B, on voit une deuxième réalisation qui utilise des diodes Zener ou des diodes connues sous les marques commerciales "Transil" ou "Transorb". Comme représenté sur la figure 6C, des circuits de type "RC", montés en série, peuvent également être utilisés. Enfin, une association des différents éléments représentés sur les figures 6A à 6C (résistance, diode, circuit de type "RC") peut également constituer un élément d'équilibrage 20.

Sur la figure 7, on a représenté schématiquement un générateur d'impulsions qui comporte un commutateur en anneau 48 du genre de ce lui qui est représenté sur la figure 3. Le générateur représenté sur la figure 7 comprend en outre un condensateur de capacité C dont une borne ao est reliée à la borne a1 du commutateur en anneau 48 et dont l'autre borne est mise à la masse. Une charge, qui est par exemple constituée par une résistance électrique rl, est montée entre la masse et la borne b1 du commutateur 48. Une source de tension non représentée est prévue pour porter, par l'intermédiaire d'une résistance de charge r, la borne ao du condensateur de capacité C à un potentiel +Vo, de va leur constante au cours du temps t, par rapport à la masse.

Le fonctionnement du générateur représenté sur la figure 7 est le suivant : la résistance de charge r permet de charger en continu le condensateur de capacité C et ce dernier est déchargé de façon impulsionnelle dans la résistance de charge rl (ou toute autre charge), grâce au commutateur en anneau 48 dont la fermeture impulsionnelle est obtenue, comme on l'a indiqué, par l'application, entre les bornes a2 et b2 (voir figure 3), d'une impulsion de tension appropriée IC.

Cette impulsion de commande du commutateur 48 permet d'obtenir, aux bornes de la charge rl, une tension Vs en forme de créneau, d'amplitude Vo (tension de charge du condensateur). La largeur de cette impulsion en créneau que l'on voit sur la figure 8 dépend essentiellement de la largeur de l'impulsion de commande qui a été appliquée au commutateur en anneau 48.

Bien entendu, on peut appliquer au commutateur 48 des impulsions de commande récurrentes, ce qui permet d'obtenir des impulsions récurrentes aux bornes de la charge rl.

Les semi-conducteurs que comporte le commutateur 48 peuvent être des transistors MOS de puissance qui permettent de commuter des tensions pouvant atteindre 10 kV. La configuration en anneau du commutateur 48 permet d'obtenir un générateur dont les performances sont particulièrement intéressantes (temps de montée rapide des impulsions produites et compacité).

Cependant, une amplitude Vo de l'ordre de 10 kV est beaucoup trop faible pour la grande majorité des applications de la présente invention, applications qui nécessitent des tensions supérieures à 100 kV. Néanmoins, le générateur représenté sur la figure 7 est très intéressant du point de vue du coût, de la compacité, de la possibilité de faire varier la durée des impulsions produites et la fréquence de récurrence de ces dernières.

La présente invention permet de remédier à l'inconvénient indiqué pour le générateur représenté sur la figure 7 (amplitude Vo des impulsions produites trop faible), en utilisant des générateurs élémentaires (de préférence un grand nombre de générateurs élémentaires) mis en série, ce qui permet d'obtenir une tension de sortie égale au produit de la tension de sortie d'un générateur élémentaire par le nombre de ces générateurs élémentaires.

Chacun de ces générateurs élémentaires comprend un commutateur qui peut être un commutateur en anneau du genre de celui qui est représenté sur la figure 3, un tel commutateur en anneau présentant de grands avantages comme on l'a déjà indiqué.

Sur la figure 9, on a représenté schématiquement un générateur d'impulsions électriques de haute tension conforme à la présente invention. Un tel générateur est également appelé "modulateur" dans le cas où il est utilisé pour alimenter des tubes à micro-ondes ou de haute fréquence.

Le générateur représenté sur la figure 9 comprend n étages en série, chaque étage gi, i variant de 1 à n, étant constitué par un générateur élémentaire qui comporte un commutateur, ce commutateur pouvant être un commutateur en anneau. Sur la figure 9, on voit cinq étages, mais le générateur pourrait comprendre jusqu'à 100 étages, voire 1000 étages.

Tous les étages sont identiques et l'étage gi, i variant de 1 à n, comprend un condensateur de capacité Ci, appelé par la suite condensateur Ci et un commutateur CAi monté entre les bornes du condensateur Ci. Le condensateur Ci est chargé par un générateur G'i qui reçoit de l'énergie en continu de la part d'un générateur Gi. En fait, au lieu de générateurs G1,..., Gn, un seul générateur suffit pour envoyer de l'énergie à tous les générateurs G'1,..., G'n.

Le générateur G'i, qui est branché entre les bornes du condensateur Ci, est prévu pour charger ce dernier. Dans certains cas (suivant la nature des générateurs G'1,..., G'n utilisés), il est préférable de prévoir une résistance de protection Rci entre une borne du générateur G'i et une borne du condensateur Ci (i variant de 1 à n). On utilise alors une résistance de faible valeur, de l'ordre de 10 ohms par exemple.

Pour fixer les potentiels, on peut également prévoir entre l'autre borne du condensateur Ci et la borne du commutateur CAi à laquelle cette autre borne du condensateur est reliée, une résistance de grande valeur rli, qui peut être de l'ordre de 10 à 100 kilo-ohms par exemple, i variant encore de 1 à n.

Les résistances Rc1,..., Rcn ont toutes la même valeur. De même, les résistances rl1,..., rln ont toutes la même valeur et les condensateur CA1,..., CAn ont tous la même capacité.

La durée de l'impulsion que l'on obtient aux bornes de rli, du fait de la décharge du condensateur Ci, décharge qui résulte de la fermeture, de façon impulsionnelle, du commutateur CAi, est commandée par les moyens de commande Ti, Li du commutateur CAi.

Les générateurs élémentaires g1,..., gn sont montés en série de façon que les impulsions électriques élémentaires respectivement produites par ces générateurs élémentaires s'ajoutent lorsque tous les condensateurs sont déchargés, comme on le voit sur la figure 9, les résistances rl1,..., rln étant ainsi montées en série. Ainsi, un générateur conforme à l'invention de n étages, dont chacun des condensateurs est chargé à la tension Vo, produit une impulsion dont l'amplitude vaut n.Vo.

On voit sur la figure 9 que dans le montage en série, la borne "libre" de la résistance rl1 de ce montage en série est mise à la masse et que l'impulsion produite par le générateur de la figure 9 est notée THT et obtenue à la borne "libre" de la résistance rln (sortie du générateur de la figure 9).

La mise en série des générateurs élémentaires impose que le potentiel de référence de chaque étage puisse subir une brusque variation.

Il convient donc que chaque étage soit à un potentiel électrique flottant, ce qui impose deux contraintes :

Premièrement, les commandes des commutateurs CA1,..., CAn doivent être isolées les unes des autres, c'est-à-dire électriquement indépendantes les unes des autres et l'on peut utiliser à cet effet des émetteurs de télécommande T1, T2,..., Tn situés au potentiel de la masse et respectivement prévus pour envoyer des impulsions de commande aux commutateurs CA1, CA2,..., CAn par l'intermédiaires de lignes de transmission L1, L2,..., Ln isolées les unes des autres.

Les signaux de commande sont ainsi acheminés sans liaison galvanique jusqu'aux bornes de commande des commutateurs. On peut par exemple utiliser une transmission de ces signaux par voie optique au moyen de fibres optiques.

Les commutateurs CA1, CA2,..., CAn doivent être déclenchés tous en même temps.

A cet effet, on peut déclencher les émetteurs T1,..., Tn tous en même temps, d'où l'envoi simultané d'impulsions lumineuses dans les fibres optiques dont les longueurs doivent alors être égales.

Si, pour des questions de construction du générateur, les longueurs des fibres optiques doivent être différentes, les déclenchements des émetteurs respectivement associés aux fibres optiques sont échelonnés dans le temps en conséquence pour que les impulsions lumineuses arrivent simultanément sur les commutateurs (ou plus précisément sur les photodétecteurs que ces commutateurs comportent alors).

Deuxièmement, les générateurs $G'1$, $G'2$,..., $G'n$, qui permettent de charger les condensateurs C1, C2,..., Cn, doivent être suffisamment isolés les uns des autres et doivent recevoir leurs énergies respectives de façon indépendante ou du moins suffisamment indépendante pour ne pas entraîner une perte excessive de puissance en sortie du générateur représenté sur la figure 9. Comme on le verra dans la suite, ceci peut être réalisé de façon inductive ou à l'aide de résistances électriques appropriées.

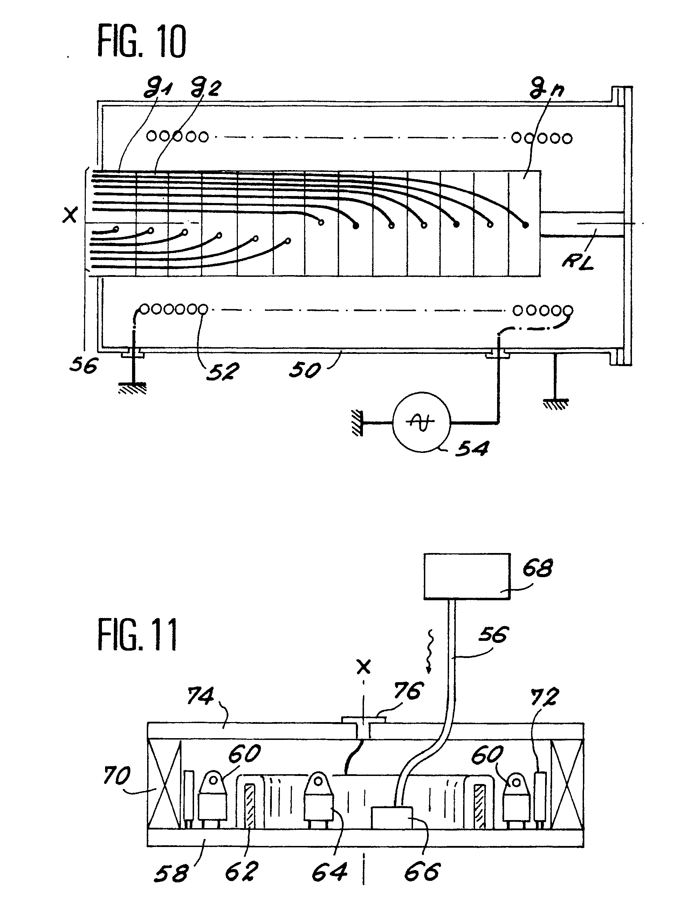

Sur la figure 10, on a représenté schématiquement un agencement particulier des générateurs élémentaires du générateur de la figure 9. Ce générateur est placé à l'intérieur d'une enceinte tubulaire 50 qui est électriquement conductrice et mise à la masse et dont l'axe est noté X. Un solénoïde 52, dont le potentiel moyen est celui de la masse, est placé à l'intérieur de l'enceinte 50 et son axe est l'axe X.

Le solénoïde 52 est alimenté, à une extrémité, par un générateur 54, apte à fournir une tension sinusoïdale de haute fréquence, de l'ordre de 20 à 100 kHz par exemple, et l'autre extrémité du solénoïde 52 est mise à la masse.

L'association du générateur 54 et du solénoïde 52 constitue l'ensemble des générateurs G1,...,Gn de la figure 9 et se trouve au potentiel de la masse.

Les commutateurs CA1,..., CAn, qui peuvent être avantageusement des commutateurs en anneau, forment un empilement à l'intérieur du solénoïde 52, l'axe de cet empilement étant l'axe X.

L'une des extrémités de l'empilement est mise à la masse tandis que l'autre extrémité de l'empilement, à laquelle est formée l'impulsion de haute tension THT, est connectée à une sortie qui peut être l'âme d'une ligne coaxiale ou directement une charge, une résistance de charge RL par exemple, très symboliquement représentée sur la figure 10.

Les commutateurs respectifs des générateurs élémentaires g1,..., gn sont commandés par des sources de lumière non représentées (diodes électroluminescentes ou diodes lasers par exemple) qui envoient des impulsions lumineuses de commande aux divers commutateurs, respectivement par l'intermédiaire de fibres optiques 56.

L'enceinte 50 peut être vide ou remplie d'un gaz pressurisé ou encore remplie d'huile, suivant les cas (type de charge utilisée), l'étanchéité de l'enceinte étant prévue en conséquence.

Sur la figure 11, on a représenté schématiquement et partiellement l'un des générateurs élémentaires qui sont utilisés dans le générateur représenté sur la figure 10, dans le cas particulier où les commutateurs sont des commutateurs en anneau. Cette figure 11 permet de comprendre l'agencement des divers composants du générateur élémentaire.

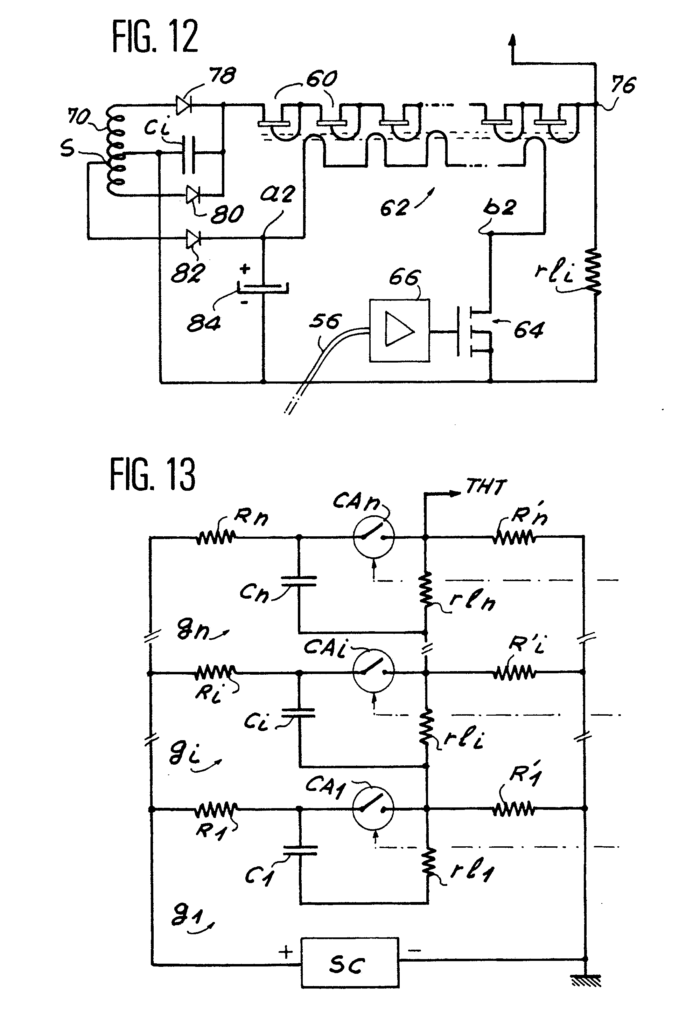

Tous ces composant s sont fixés sur un circuit imprimé 58, ce qui permet de réaliser le circuit électrique représenté sur la figure 12 qui sera décrite par la suite.

On voit sur la figure 11 les dispositifs semi-conducteurs du commutateur en anneau. Dans l'exemple représenté, ces dispositifs semi-conducteurs sont des transistors qui sont ici référencés 60. Ces transistors sont commandés par le transformateur torique du commutateur, transformateur qui porte ici la référence 62. Ce transformateur torique 62 est commandé par l'intermédiaire d'un transistor de puissance 64 de type MOS (relié au circuit primaire du transformateur torique). Ce transistor 64 est lui-même commandé par un photorécepteur 66 qui est activé par le signal lumineux transmis par la fibre optique 56 correspondant au générateur élémentaire de la figure 11.

Ainsi, une extrémité de la fibre optique 56 aboutit au photorécepteur 66 tandis que l'autre extrémité de la fibre optique 56 aboutit à un émetteur de lumière 68 prévu pour injecter dans la fibre 56 une impulsion lumineuse de commande du commutateur.

A la périphérie du commutateur en anneau de la figure 11 se trouve une bobine 70 dont l'axe est l'axe X et qui est destinée à capter le champ électromagnétique induit dans l'enceinte 50 par le solénoïde 52, de façon à charger le condensateur du générateur élémentaire de la figure 11 par l'intermédiaire de moyens de redressement de tension non représentés sur la figure 11.

En fait, pour des questions de tenue en tension, ce condensateur est remplacé par une pluralité de condensateurs montés en série et ces condensateurs montés en série forment une couronne 72 dont l'axe est l'axe X et qui est disposée à l'intérieur de la bobine 70, comme on le voit sur la figure 11.

On notera que le générateur $G'_i$ du générateur élémentaire de la figure 11 est constitué par la bobine 70 et par les moyens de redressement de tension non représentés qui sont associés à cette bobine.

Le générateur élémentaire de la figure 11 est fermé par une plaque électriquement isolante 74 qui soie ce générateur élémentaire du générateur élémentaire adjacent, la bobine 70 étant ainsi comprise entre la plaque du circuit imprimé 58 et la plaque 74. Sur la face externe de la plaque 74 se trouve une borne 76 permettant de relier la sortie du générateur élémentaire de la figure 11 au générateur élémentaire suivant.

Le schéma électrique du générateur élémentaire de la figure 11 est donné sur la figure 12.

Une borne de la bobine 70 est reliée à l'anode d'une diode 78 et l'autre borne de la bobine 70 est reliée à l'anode d'une autre diode 80.

Une borne du condensateur $C_i$ (ou plus exactement une extrémité du montage en série des condensateurs formant la couronne 72) est reliée aux cathodes des diodes 78 et 80. L'autre borne du condensateur $C_i$ est reliée à un point médian de la bobine 70 ainsi qu'à la borne - d'un condensateur électrolytique 84 dont la borne + est reliée à la cathode d'une diode 82. L'anode de cette diode 82 est reliée à une sortie basse tension S de la bobine 70.

Le montage en série des transistors 60 de type MOS relie la cathode de la diode 78 à la borne 76. Le photodétecteur 66, qui reçoit des signaux lumineux par l'intermédiaire de la fibre optique 56, fournit en sortie une tension de commande appliquée à la grille du transistor 64 de type MOS dont la source est reliée d'une part à la borne - du condensateur 84 et d'autre part à la borne 76 par l'intermédiaire de la résistance $r_{li}$. Le drain de ce transistor 64 est relié à une borne du circuit primaire du transformateur torique 62 dont l'autre borne est reliée à la cathode de la diode 82.

Ainsi, le circuit primaire du transformateur torique 62 est commandé par le transistor 64. Ce dernier est alimenté en tension continue qui est obtenue par redressement de la tension prélevée à la sortie basse tension S, au moyen de la diode 82, et filtrage de la tension redressée par le condensateur 84. On voit que le redressement peut n'être effectué qu'à une seule alternance, compte tenu du très faible courant moyen fourni par le transistor 64.

La position de la sortie basse tension S est telle que l'on ne prélève par son intermédiaire qu'une fraction, par exemple le dixième, de la tension aux bornes de la bobine 70.

La réalisation particulière de l'invention, qui est schématiquement et partiellement représentée sur la figure 13, utilise un transfert d'énergie aux condensateurs $C_1$,..., $C_n$ au moyen d'un réseau de résistances électriques.

Chaque étage du générateur de la figure 13 comporte deux telles résistances électriques. Ces deux résistances sont notées $R_i$ et $R'_i$ pour l'étage i, variant de 1 à n. Une borne de la résistance $R_i$ est reliée à une borne de sortie du commutateur $CA_i$ et une borne de la résistance $R'_i$ est reliée à l'autre borne de sortie du commutateur $CA_i$ (ces bornes de sortie portant les références a1 et b1 sur la figure 3).

Le générateur représenté sur la figure 13 comprend également une source de tension continue SC dont la borne + est reliée aux autres bornes des résistances $R_1$,..., $R_i$,..., $R_n$ et dont la borne - est mise à la masse et reliée aux autres bornes des résistances $R'_1$,..., $R'_i$,..., $R'_n$.

La tension fournie par la source SC est par exemple de l'ordre de 10kV et correspond à l'ensemble des générateurs $G_1$,..., $G_n$ de la figure 9.

Dans le cas de la figure 13, les différents étages $g_1$,..., $g_n$ ne sont pas isolés les uns des autres et il se produit des fui tes de courant électrique.

Cependant, l'isolement entre les différents étages doit être suffisant pour que les courants dérivés, ou courants de fuite, soient négligeables devant le courant qui est transmis à la charge à laquelle est relié le générateur de la figure 13, cette transmission ayant lieu par l'intermédiaire de la sortie de ce générateur (sortie où est produite l'impulsion THT). On considère que l'isolement est acceptable si la somme des intensités des courants dérivés ne dépasse pas 10% de l'intensité du courant transmis à la charge.

La structure du générateur représenté sur la figure 13 ressemble quelque peu à un générateur de MARX qui utiliserait des commutateurs dont il serait possible de commander non seulement la fermeture, mais également l'ouverture, des commutateurs transistorisés par exemple. Cependant, à la différence d'un générateur de MARX, le générateur de la figure 13 ne fournit qu'une faible fraction de l'énergie stockée dans les condensateurs $C_1$,...,

Cn. Ce générateur ne fonctionne dans de bonnes conditions que si le facteur de forme des impulsions (rapport de la durée d'une impulsion à la période de ces impulsions) est très faible.

Les résistances R1,..., Rn, R'1,..., R'n ont toutes la même valeur qui est choisie suffisamment grande pour que les courants parasites, ou courants de fuite, dont il a été question plus haut, ne soient pas trop élevés. Cette valeur commune à toutes ces résistances est par exemple de l'ordre de 100 kilo-ohms. L'importance de la valeur de ces résistances implique que le générateur représenté sur la figure 13 est surtout intéressant lorsqu'on souhaite produire des impulsions électriques de haute tension dont la fréquence de récurrence est seulement de l'ordre de quelques Hz.

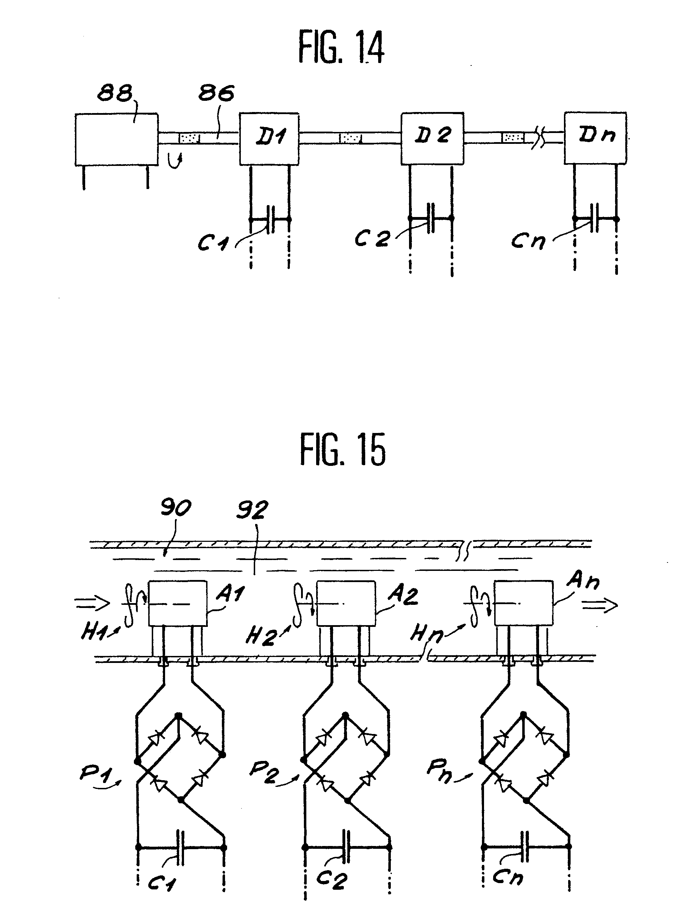

Dans les réalisations particulières qui sont schématiquement et partiellement représentées sur les figures 14 et 15, la transmission d'énergie aux générateurs G'1,.., G'n s'effectue par des moyens mécaniques.

Sur la figure 14, les générateurs G'1,..., G'n sont des dynamos qui chargent respectivement les condensateurs C1,..., Cn et qui sont entraînées simultanément en rotation au moyen d'un arbre 86 lui-même entraîné en rotation par un moteur 88 placé au potentiel de la masse. L'arbre 86 comporte des tronçons qui sont électriquement isolés les uns des autres et qui sont respectivement associés aux dynamos, chacune de ces dernières étant mise en rotation grâce au tronçon qui lui est associé.

Bien entendu, au lieu de dynamos, on pourrait utiliser des alternateurs pour charger les différents condensateurs, par l'intermédiaire de ponts redresseurs.

Dans la réalisation de la figure 15, les générateurs G'1,..., G'n sont des alternateurs dont les rotors sont respectivement munis d'hélices H1,..., Hn et qui sont placés à l'intérieur d'une canalisation 90 dans laquelle circule un fluide 92 électriquement isolant, par exemple de l'huile, qui entraîne en rotation les héli ces H1,..., Hn. Les conducteurs de sortie des différents alternateurs traversent la canalisation 90 par l'intermédiaire de passages étanches et électriquement isolants pour aboutir respectivement à des ponts redresseurs P1,..., Pn permettant la charge des condensateurs C1,..., Cn.

Bien entendu, au lieu d'alternateurs, on pourrait utiliser des dynamos permettant de charger directement les condensateurs C1,..., Cn.

**Revendications**

1. Générateur d'impulsions électriques, caractérisé en ce qu'il comprend :
- une pluralité de générateurs d'impulsions électriques élémentaires (g1,..., gn) qui sont montés en série, chaque générateur d'impulsions électriques élémentaires comprenant :
- des moyens (C1, ..., Cn) d'accumulation d'énergie électrique, et
- un commutateur (CA1, ..., CAn) dont la fermeture provoque la décharge des moyens d'accumulation d'énergie électrique,
- des moyens (T1-L1, ..., Tn-Ln) de commande des commutateurs, ces moyens de commande étant électriquement indépendants les uns des autres et prévus pour fermer simultanément les commutateurs de façon impulsionnelle, le montage en série des générateurs d'impulsions électriques élémentaires étant tel que le générateur produise alors une impulsion électrique de grande amplitude, égale à la somme des impulsions électriques élémentaires résultant de la fermeture simultanée des commutateurs, et
- des moyens (G1-G'1, ..., Gn-G'n) de chargement en énergie électrique des moyens d'accumulation, moyens de chargement dont la dépendance électrique mutuelle est nulle ou en tout cas suffisamment faible pour ne pas entraîner une perte excessive de puissance en sortie du générateur.

2. Générateur selon la revendication 1, caractérisé en ce que les générateurs d'impulsions électriques élémentaires (g1,..., gn) sont empilés suivant un axe (X) et placés dans une enceinte (50) qui est électriquement conductrice et mise à la masse et qui a la forme d'un tube dont l'axe est celui de l'empilement des générateurs d'impulsions électriques élémentaires, ces derniers formant le conducteur interne d'une ligne coaxiale dont le conducteur externe est formé par l'enceinte.

3. Générateur selon l'une quelconque des revendications 1 et 2, caractérisé en ce que chaque commutateur (CA1,..., CAn) comprend :
- une pluralité de dispositifs semi-conducteurs (2), chaque dispositif semi-conducteur comportant un ensemble de deux électrodes (4, 6), entre lesquelles le signal de sortie relatif à ce dispositif semi-conducteur est disponible, et une électrode de commande (8), les dispositifs semi-conducteurs étant montés en série par l'intermédiaire des ensembles de deux électrodes,
- une pluralité de transformateurs toriques (10) qui sont respectivement associés aux dispositifs semi-conducteurs, chaque transformateur comportant un circuit primaire (14), un noyau (16) en forme d'anneau et un circuit secondaire (18), le noyau en forme d'anneau et le circuit primaire étant communs à tous les transformateurs toriques, les dispositifs semi-conducteurs étant disposés suivant un cercle entourant le noyau en forme d'anneau, le circuit primaire faisant office de circuit de commande du commutateur, chaque circuit secondaire étant monté entre l'électrode (8) de commande du dispositif semi-conducteur correspondant et l'une (6) des deux électrodes de ce dernier, entre lesquelles le signal de sortie relatif à ce dispositif est disponible, et

- une pluralité d'éléments d'équilibrage (20) qui sont respectivement associés aux dispositifs semiconducteurs et qui sont prévus pour assurer l'équilibrage des tensions entre tous ces dispositifs semi-conducteurs, chaque élément d'équilibrage étant monté entre les deux électrodes de l'ensemble de deux électrodes du dispositif semi-conducteur correspondant.

4. Générateur selon l'une quelconque des revendications 1 à 3, caractérisé en ce que les moyens (T1-L1,..., Tn-Ln) de commande des commutateurs sont de type photo-électrique.

5. Générateur selon la revendication 4, caractérisé en ce que les moyens de commande des commutateurs comprennent :

- des fibres optiques (56) qui sont respectivement associées aux commutateurs,

- des moyens (68) d'émission de lumière et d'injection de celle-ci à une extrémité de chaque fibre optique, et

- à l'autre extrémité de chaque fibre optique, des moyens (66) de détection de la lumière et d' activation du commutateur associé.

6. Générateur selon l'une quelconque des revendications 1 à 5, caractérisé en ce que les moyens de chargement (G1-G'1,..., Gn-G'n) des moyens d'accumulation sont de type inductif.

7. Générateur selon la revendication 6, caractérisé en ce que les moyens de chargement des moyens d' accumulation comprennent :

- des moyens (52, 54) d'émission d'ondes électromagnétiques de haute fréquence et

- pour chaque générateur d'impulsions électriques élémentaires, une bobine d'induction (70) qui est prévue pour détecter ces ondes et qui est reliée aux moyens (Ci) d'accumulation d'énergie électrique correspondants par l'intermédiaire de moyens (78, 80) de redressement de tension.

8. Générateur selon l'une quelconque des revendications 1 à 5, caractérisé en ce que les moyens de chargement des moyens d' accumulation comprennent :

- pour chaque générateur d'impulsions électriques élémentaires (g1,..., gn), deux résistances électriques (R1-R'1,..., Rn-R'n) respectivement connectées aux bornes des moyens d' accumulation d'énergie électrique correspondants (C1,..., Cn), et

- une source (SC) de tension électrique continue dont une borne est mise à la masse et qui est montée entre les bornes des moyens d' accumulation de chaque générateur d'impulsions électriques élémentaires par l'intermédiaire des résistances électriques correspondantes, les valeurs des résistances électriques du générateur étant suffisamment faibles pour ne pas entraîner une perte excessive de puissance en sortie du générateur.

9. Générateur selon l 'une quelconque des revendications 1 à 5, caractérisé en ce que les moyens (G1-G'1,..., Gn-G'n) de chargement des moyens d'accumulation sont de type mécanique.

10. Générateur selon la revendication 9, caractérisé en ce que les moyens de chargement des moyens d'accumulation comprennent :

- une pluralité de moyens électriques rotatifs (D1, ..., Dn), qui sont respectivement associés aux générateurs d'impulsions électriques élémentaires, chaque moyen électrique rotatif étant prévu pour appliquer, lorsqu'il tourne, une tension électrique continue entre les bornes des moyens d' accumulation d'énergie électrique du générateur d'impulsions électriques élémentaires associé,

- un arbre rotatif (86) comportant des tronçons qui sont électriquement isolés les uns des autres, qui sont respectivement associés aux moyens rotatifs et qui sont prévus pour entraîner en rotation ces moyens rotatifs, et

- des moyens (88) de rotation de l'arbre.

11. Générateur selon la revendication 9, caractérisé en ce que les moyens de chargement des moyens d'accumulation comprennent :

- une pluralité de moyens électriques rotatifs (A1-P1,..., An-Pn), qui sont respectivement associés aux générateurs d'impulsions électriques élémentaires, chaque moyen électrique rotatif étant prévu pour appliquer, lorsqu'il tourne, une tension électrique continue entre les bornes des moyens d'accumulation d'énergie électrique du générateur d'impulsions électriques élémentaires associé,

- des moyens d'entraînement (H1,..., Hn) aptes à entraîner en rotation ces moyens rotatifs sous l'effet d'un fluide en circulation, et

- une canalisation (90) qui est destinée à la circulation d'un fluide (92) électriquement isolant et dans laquelle sont placés les moyens d'entraînement.

FIG. 1

FIG. 2

FIG. 7

FIG. 8

EP 0 415 836 A1

FIG. 3

FIG. 4

FIG. 5

FIG. 6

FIG.9

FIG. 10

FIG. 11

# FIG. 12

# FIG. 13

# FIG. 14

# FIG. 15

Office européen
des brevets

**RAPPORT DE RECHERCHE
EUROPEENNE**

Numéro de la demande

**EP 90 40 2368**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | ELECTRONICS, vol. 35, no. 37, 14 septembre 1962, pages 42-45, New York, US; F.A. GATEKA et al.: "Semiconductor modulators for modern magnetrons" * Page 42, photographie de droite, page 43, colonne du milieu, ligne 26 - colonne de droite, ligne 24; page 44, colonne de droite, lignes 33-44; figure 2(B) * — — — | 1-3,8 | H 03 K 3/53 H 03 K 3/57 |
| A | US-A-4 107 757 (MASUDA et al.) * Colonne 6, lignes 11-31; colonne 15, ligne 43 - colonne 17, ligne 1; figures 1,11,12 * — — — | 6,7 | |
| A | US-A-4 050 004 (GREATBATCH) * Colonne 2, ligne 61 - colonne 5, ligne 48; figure 1 * — — — — — | 8 | |

**DOMAINES TECHNIQUES RECHERCHES (Int. Cl.5)**

H 03 K

Le présent rapport de recherche a été établi pour toutes les revendications

| Lieu de la recherche | Date d'achèvement de la recherche | Examinateur |
|---|---|---|
| La Haye | 07 décembre 90 | CANTARELLI R.J.H. |